(19) Europäisches Patentamt / European Patent Office / Office européen des brevets

(11) **EP 2 036 116 B1**

(12) **FASCICULE DE BREVET EUROPEEN**

(45) Date de publication et mention de la délivrance du brevet:
**09.03.2016 Bulletin 2016/10**

(51) Int Cl.:
***H01L 49/02*** *(2006.01)*

(21) Numéro de dépôt: **07803780.1**

(22) Date de dépôt: **26.06.2007**

(86) Numéro de dépôt international:
**PCT/FR2007/001068**

(87) Numéro de publication internationale:
**WO 2008/000949 (03.01.2008 Gazette 2008/01)**

(54) **DISPOSITIF ET PROCÉDÉ À CAPACITÉ COMMANDABLE**

VORRICHTUNG MIT EINSTELLBARER KAPAZITÄT UND HERSTELLUNGSVERFAHREN DAFÜR

ADJUSTABLE CAPACITY DEVICE AND PROCESS THEREOF

(84) Etats contractants désignés:
**AT BE BG CH CY CZ DE DK EE ES FI FR GB GR HU IE IS IT LI LT LU LV MC MT NL PL PT RO SE SI SK TR**

(30) Priorité: **30.06.2006 FR 0605952**

(43) Date de publication de la demande:
**18.03.2009 Bulletin 2009/12**

(73) Titulaire: **Centre National de la Recherche Scientifique (CNRS)**
**75794 Paris Cedex 16 (FR)**

(72) Inventeurs:
• **KLEIDER, Jean-Paul**
  **F-91440 Bures-Sur-Yvette (FR)**
• **GODET, Christian**
  **F-35000 Rennes (FR)**
• **GUDOVSKIKH, Alexander**
  **194291 Saint Petersburg (RU)**

(74) Mandataire: **Novagraaf Technologies**
**Bâtiment O2**
**2, rue Sarah Bernhardt**
**CS90017**
**92665 Asnières-sur-Seine Cedex (FR)**

(56) Documents cités:
**WO-A2-02/23633      US-A1- 2004 207 486**

• **BEALE M ET AL: "THE ORIGINS AND CHARACTERISTICS OF NEGATIVE CAPACITANCE IN METAL-INSULATOR-METAL DEVICES" PHYLOSOPHICAL MAGAZINE B, XX, XX, vol. 65, no. 1, janvier 1992 (1992-01), pages 47-64, XP008074916 ISSN: 0141-8637**
• **PENIN N A: "Negative capacitance in semiconductor structures" SEMICONDUCTORS AIP USA, vol. 30, no. 4, avril 1996 (1996-04), pages 340-343, XP008074929 ISSN: 1063-7826**
• **MAXIM ERSHOV ET AL: "Negative Capacitance Effect in Semiconductor Devices" IEEE TRANSACTIONS ON ELECTRON DEVICES, IEEE SERVICE CENTER, PISACATAWAY, NJ, US, vol. 45, no. 10, octobre 1998 (1998-10), XP011016684 ISSN: 0018-9383**

## Description

La présente invention se rapporte à un dispositif permettant de faire varier la valeur apparente d'une capacité.

La présente invention se rapporte également à un procédé permettant de faire varier la valeur apparente d'une capacité.

Dans le cadre de certaines applications dans le domaine de l'électronique, on est amené à contrôler le caractère capacitif ou inductif de l'impédance ou l'admittance d'un circuit, ou à devoir compenser les effets indésirables d'une capacité dans un circuit.

Dans l'art antérieur, une solution connue est de produire une capacité ayant une valeur négative, comme il est décrit dans la demande de brevet US 5558477, qui se rapporte à un dispositif comprenant un circuit à réactance négative comportant un amplificateur, un condensateur chargé, une résistance, un diviseur de tension et qui est connecté à un équipement piézoélectrique. Ce circuit a pour fonction de simuler une capacité négative afin de compenser la capacité de cet équipement, ceci ayant pour effet de contrôler les actions mécaniques de cet équipement sur la base de ses propriétés électromécaniques.

On connaît aussi dans la demande internationale PCT WO 96/28847 un dispositif électronique comprenant deux noeuds et présentant des moyens pour compenser l'impédance capacitive entre ces noeuds. Ces moyens comprennent des éléments discrets associés à une diode à jonction polarisée en régime d'avalanche qui reproduit le comportement d'une capacité négative afin de compenser, et dans certains cas d'annuler une capacité parasite positive connectée en parallèle.

L'inconvénient de tels dispositifs est qu'ils ne permettent pas de faire varier la capacité. Par ailleurs, ils nécessitent une large surface pour être incorporés sur un circuit intégré. De plus ces dispositifs sont de réalisation complexe et coûteuse.

Il est aussi connu de pouvoir obtenir des capacités négatives sur la base de matériaux, de type organique ou incluant des nano-particules ou nanotubes, entrant dans la composition de semi-conducteurs.

C'est le cas par exemple de polymères organiques comme il est exposé dans la publication :

« Modeling negative capacitance effect in organic polymers » dans la revue « Solid-state-electronics.», année 2003 pages 1089-1093 ayant pour auteur KWOK-H-L,

ou encore le cas pour des nano tubes de carbone dans la publication :

« Negative quantum capacitance of gated carbon nanotubes » dans la revue « Physical-Review-B-Condensed-Matter-and-Materials-Physics. » du 15 juillet 2005, pages 35455-1-5 avec les auteurs « Latessa,-L.; Pecchia,-A.; Di-Carlo,-A.; Lugli,-P».

L'inconvénient de ces matériaux et notamment ceux de type organique, est que ceux-ci souffrent de problèmes de vieillissement et de fiabilité. Pour d'autres matériaux, ils peuvent présenter des problèmes d'incompatibilités avec les technologies du silicium, et leur réalisation est complexe et onéreuse. De plus ils ne permettent pas de faire varier une capacité.

On connaît aussi dans l'art antérieur la publication :

« High-field transport in amorphous carbon and carbon nitride films » dans la revue « Journal of Non-Crystalline Solids » du 15 juin 2004, Volumes 338-340, pages 349-352 avec les auteurs Kleider-JP, Gudovskikh-A., Godet-C.

Ce document enseigne un dispositif comprenant un dipôle, ledit dipôle comprenant un matériau semi-conducteur à transport électronique par saut positionné entre une première électrode et une deuxième électrode. De plus il décrit des matériaux présentant des propriétés de transport électronique et en particulier de transport par saut dans des états localisés, tel que le nitrure de carbone amorphe hydrogéné, qui placé dans un dispositif métal/nitrure de carbone amorphe hydrogéné/métal prend des valeurs d'admittance différentes pour une tension continue ou alternative donnée appliquée audit dispositif, en fonction d'une température ou d'une fréquence.

On connait également dans l'état de l'art le document US 2004/207486, ainsi que les publications ayant pour titre :

- "The origins and characteristics of negative capacitance in metal-insulator-metal devices", dont l'auteur est M.BEALE ;
- "Negative capacitance in semiconductor structures", dont l'auteur est N.A.PENIN.

La présente invention entend remédier aux inconvénients de l'art antérieur.

Plus particulièrement, un des buts de l'invention est de faire varier la valeur apparente d'une capacité.

Un autre but de l'invention est de proposer un dispositif compact et intégrable dans un circuit intégré.

Pour ce faire, la présente invention concerne un dispositif pour faire varier la valeur apparente d'une capacité, tel que défini par la revendication 1, ledit dispositif étant caractérisé en ce qu'il comprend :

- un dipôle de type connu en soi, comprenant un matériau semi-conducteur à transport électronique par saut positionné entre une première électrode et une deuxième électrode, ledit dipôle étant disposé en parallèle de ladite capacité, ledit dipôle se composant d'un substrat de verre, d'une couche d'un alliage de nitrure de carbone amorphe hydrogéné constituant le semi-conducteur et d'une couche d'aluminium pour chacune des électrodes,

- un générateur de tension continue relié électriquement à la deuxième électrode et à la première électrode dudit dipôle;
- des moyens pour faire varier la tension générée par le générateur.

Dans un tel dispositif où le dipôle, le générateur de tension continue et la capacité sont en parallèle, la variation de la tension aux bornes du dipôle fait varier la capacité de l'ensemble du dispositif.

Dans une variante, le dispositif comprend un générateur de tension alternative disposé en série avec ledit générateur de tension continue.

Dans une variante, la première électrode comprend une ligne métallique de première électrode et une surface de contact de première électrode, et la deuxième électrode comprend une ligne métallique de deuxième électrode et une surface de contact de deuxième électrode, ledit matériau semi-conducteur étant positionné entre ladite ligne métallique de première électrode et ladite ligne métallique de deuxième électrode, ledit générateur étant relié électriquement à la première électrode et à la deuxième électrode respectivement au niveau de la surface de contact de première électrode et de la surface de contact de deuxième électrode.

Cette structure du dipôle offre l'avantage de pouvoir être insérée assez facilement dans des circuits intégrés à partir des surfaces de contact de première électrode et de deuxième électrode.

Dans une autre variante, le dipôle se compose d'un substrat de verre et d'une succession de couches suivantes :

- une couche d'aluminium constituant la première électrode,
- une couche d'un alliage titane tungstène,
- une couche d'un alliage de nitrure de carbone amorphe hydrogéné constituant le semi-conducteur,
- une couche d'un alliage de titane tungstène,
- et une couche d'aluminium constituant la deuxième électrode.

On peut noter que lorsque les électrodes du dipôle sont réalisées à partir du même métal ou du même assemblage de métaux, ses propriétés électriques ne dépendent pas du signe de la tension appliquée.

L'invention concerne aussi un procédé pour faire varier la valeur apparente d'une capacité, tel que défini par la revendication 5, ledit procédé comprenant des étapes consistant à :

- positionner en parallèle :

  • ladite capacité,
  • un dipôle de type connu en soi, comprenant un matériau semi-conducteur à transport électronique par saut positionné entre une première électrode et une deuxième électrode,
  ledit dipôle se composant d'un substrat de verre, d'une couche d'un alliage de nitrure de carbone amorphe hydrogéné constituant le semi-conducteur et d'une couche d'aluminium pour chacune des électrodes,
  • et un générateur de tension continue relié électriquement à la première électrode et à la deuxième électrode,

- appliquer une tension continue aux bornes de ladite première électrode et de ladite deuxième électrode,
- faire varier ladite tension générée par le générateur.

Ce procédé permet de faire varier la valeur apparente d'une capacité, qui peut être un condensateur ou un circuit électrique ayant une capacité équivalente, en faisant varier la tension continue aux bornes du dipôle.

Dans un mode de réalisation, ce procédé comprend une étape consistant à faire varier ladite tension jusqu'à une valeur, ladite valeur étant choisie de sorte que la valeur apparente de ladite capacité soit négative.

Cette étape du procédé offre l'avantage de pouvoir, par la variation de la tension obtenir une valeur apparente de la capacité négative pour une tension donnée.

Dans une variante, ce procédé comprend une étape consistant à faire varier ladite tension jusqu'à une valeur, ladite valeur étant choisie de sorte que la valeur apparente de ladite capacité soit nulle.

Dans une variante, ce procédé comprend une étape consistant à sélectionner une fréquence d'une tension alternative générée par le générateur de tension alternative lorsque ladite tension continue est fixée, de telle sorte que la valeur apparente de ladite capacité (12) soit négative.

Dans une variante, ce procédé comprend une étape consistant à sélectionner une fréquence d'une tension alternative générée par le générateur de tension alternative lorsque ladite tension continue est fixée, de telle sorte que la valeur apparente de ladite capacité (12) soit nulle.

La fréquence d'une tension alternative est générée par le générateur de tension alternative qui est disposé en série avec le générateur de tension continue lorsque la capacité correspond à un condensateur. Pour une capacité correspondant à un circuit présentant une capacité équivalente cette fréquence d'une tension alternative correspond au générateur de tension alternative qui alimente ce circuit.

On décrit maintenant un mode de réalisation de l'invention, en référence aux figures annexées où :

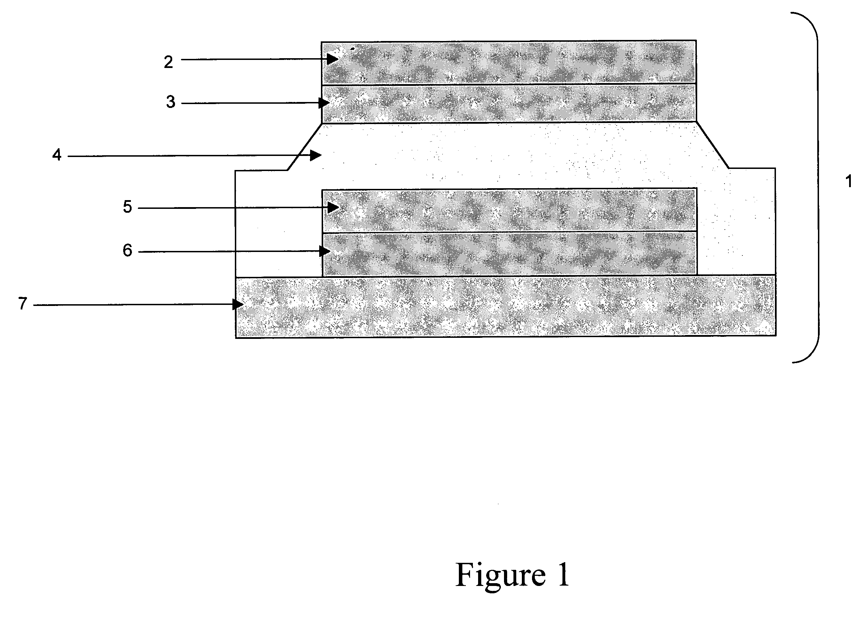

- la figure 1 illustre une vue du dipôle en coupe ;

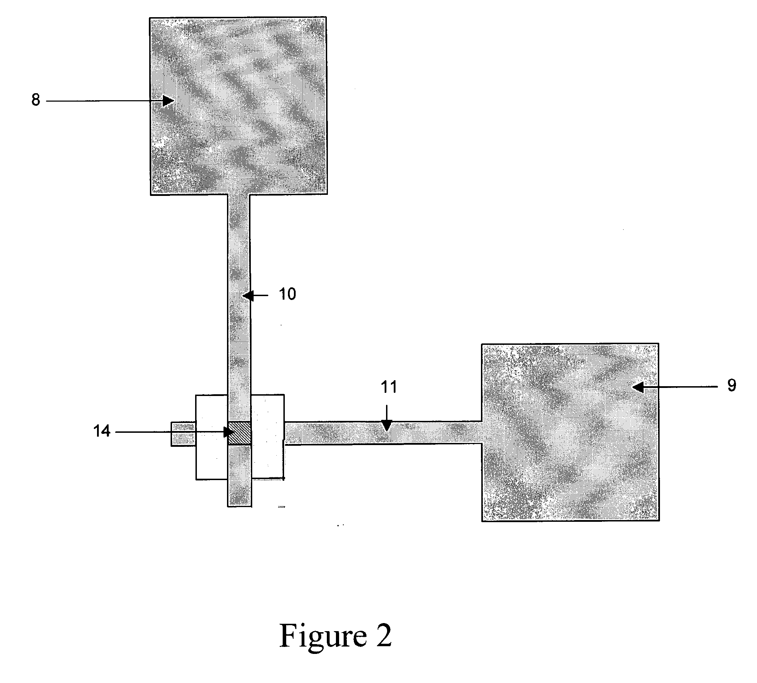

- la figure 2 illustre une vue de dessus du dipôle ;

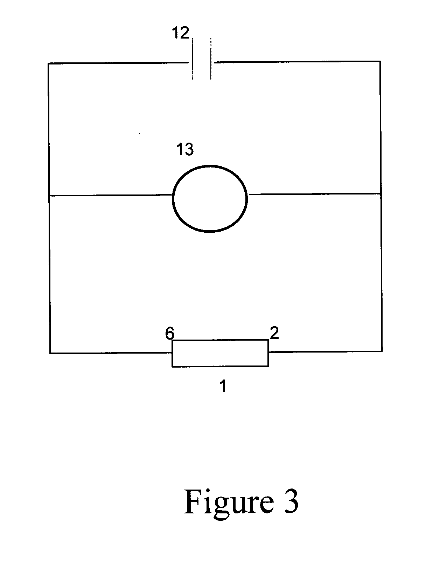

- la figure 3 illustre un mode de réalisation de l'invention ;

- la figure 4 correspond à un graphique des valeurs de la capacité du dipôle en fonction de la valeur de la tension continue appliquée ;
- la figure 5 correspond à un graphique des valeurs de la capacité du dispositif en fonction de la fréquence pour différentes valeurs de la tension continue ;

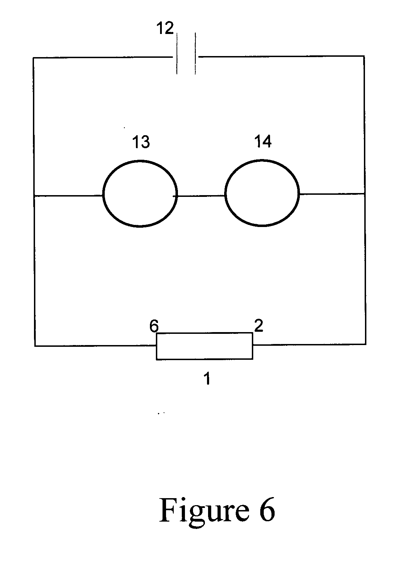

- la figure 6 est un mode de réalisation de l'invention,

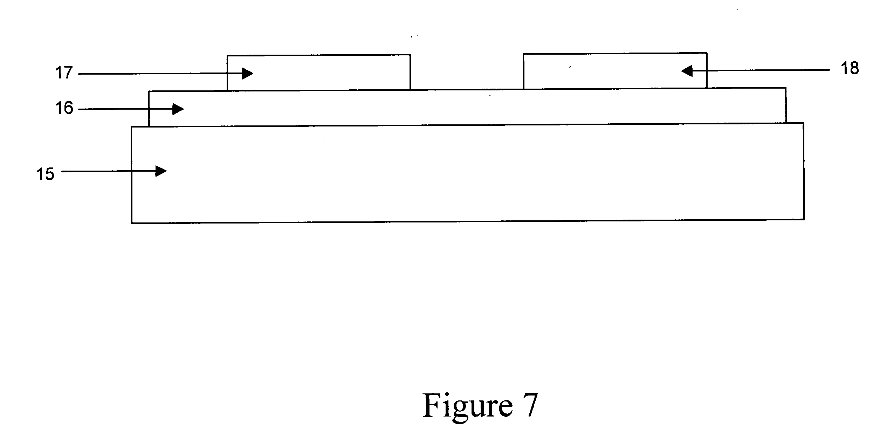

- la figure 7 illustre une vue en coupe d'un dipôle ayant une structure coplanaire.

Dans un mode de réalisation, l'invention se rapporte à un dispositif qui est intégré au sein d'un circuit. Ce circuit comprend notamment un condensateur $C_{ext}$ 12 qui introduit des temps de réponses dans ledit circuit. En réduisant la capacité du condensateur $C_{ext}$ 12, le temps de réponse du circuit s'en trouve réduit et donc amélioré. À travers le dispositif mis en oeuvre par l'invention il est possible de réduire la valeur apparente du condensateur $C_{ext}$ 12 afin d'améliorer les temps de réponses.

Pour cela le dispositif comprend un dipôle 1, et un générateur de tension continu 13, qui sont montés en parallèle avec le condensateur $C_{ext}$ 12. Le générateur de tension est relié à un ordinateur qui permet de faire varier cette tension.

Dans un autre mode de réalisation, $C_{ext}$ 12 est un circuit électrique ou un dipôle quelconque ayant une capacité équivalente.

Le dipôle, dans sa structure, est constitué de plusieurs couches successives réalisées par différents dépôts.

Un premier dépôt d'aluminium 6 d'une épaisseur de 150 nm est présent sur le substrat de verre 7 pour une électrode métallique inférieure, une première électrode 6. Sur cette première couche un dépôt très mince de 15 nm d'un alliage de titane tungstène 5 fait office de barrière contre la diffusion éventuelle d'atomes de et vers la couche semi-conductrice. Sur cette deuxième couche est déposé un matériau semi-conducteur à transport électronique par saut 4. Ce matériau semi-conducteur à transport électronique par saut 4 correspond par exemple à un alliage de nitrure de carbone amorphe hydrogéné ou encore à tout autre matériau désordonné avec des états électroniques localisés. Le nitrure de carbone amorphe est réalisé par ECR-PECVD (Electron Cyclotron Resonance Plasma Enhanced Chemical Vapour Deposition). Ce dépôt est fait à une température de 300 K à partir de la décomposition d'un mélange d'acétylène et d'azote. L'épaisseur de cette couche de 50 nm est déterminée par une technique d'analyse appropriée pour la mesure d'épaisseur de couches minces telle que l'ellipsométrie.

Dans une variante, on peut utiliser un matériau semi-conducteur à transport électronique par saut tel qu'un nitrure de carbone amorphe avec des épaisseurs et des compositions différentes. Ces deux paramètres, épaisseur et composition, permettent d'influer sur les valeurs de tension continue et de la fréquence du générateur de tension alternative 14.

Sur cette troisième couche, un dépôt d'un alliage titane tungstène 3 similaire à la deuxième couche est effectué avec une épaisseur de 15nm. De la même façon, sur cette quatrième couche un dépôt d'aluminium est fait pour une électrode supérieure la deuxième électrode 2. Cette cinquième et dernière couche d'épaisseur 150nm est symétrique à la première couche.

Il est possible de faire varier les épaisseurs des couches métalliques ainsi que de remplacer l'alliage titane-tungstène et l'aluminium par d'autres métaux, tout en gardant les propriétés du dispositif.

La structure ainsi obtenue est parfaitement symétrique. Cette symétrie permet à ce dipôle de fonctionner aussi bien pour des tensions positives que négatives. Par ailleurs, on peut noter que pour une telle structure des valeurs de conductivité obtenues par des mesures de courant continu en fonction d'une tension continue appliquée entre la première électrode 2 et la deuxième électrode 6 sont identiques aux valeurs déduites de mesures en continu réalisées sur des structures coplanaires obtenues par dépôt de nitrure de carbone amorphe hydrogéné 16, de formule chimique a-CN:H, sur un substrat de verre 15, et munies de deux électrodes coplanaires d'aluminium 17,18.

La première électrode 2 et la deuxième électrode 6 sont constituées respectivement de deux lignes 10, 11 perpendiculaires munies de surfaces de contact 8, 9 de forme carrée à une de leur extrémité, afin de faciliter la prise de contact avec un circuit intégré ou un générateur de courant. L'intersection des deux lignes perpendiculaires 10, 11 définit une surface active 14 du dipôle 1.

Pour des largeurs de lignes, de 5 à 200 microns, la surface active 14 du dipôle 1 est de 25 à 40000 $\mu m^2$. Le courant circulant dans le dispositif est proportionnel à sa surface active. Ceci permet de miniaturiser ce dipôle 1.

Dans le circuit, deux fils de cuivre relient respectivement la surface de contact de la première électrode 8 et de la deuxième électrode 9 à des embases de connecteurs BNC (connecteur Bayonet Neill-Concelman). Ces fils de cuivre sont fixés sur ces surfaces de contact par collage. La colle utilisée est de la laque d'argent pour ses propriétés de conductivité. Les fils de cuivre reliant le dipôle aux embases BNC sont volontairement courts afin de minimiser les impédances parasites. Sur ces embases viennent se fixer des câbles BNC (connecteur Bayonet Neill-Concelman). Ce sont des câbles coaxiaux qui ont en leur terminaison un modèle de connecteur RF (radiofréquence). Le blindage de ces câbles permet une transmission fidèle d'un signal. Sur ces mêmes embases, est branché le condensateur du circuit $C_{ext}$.

L'autre extrémité des câbles BNC est reliée à un instrument de mesure qui est un impédancemètre de précision par exemple de la marque AGILENT, modèle 4284A. Cet appareil muni de l'option 01 possède un générateur de tension continu 13 permettant d'appliquer une polarisation continue et un générateur de tension alternative 14 monté en série permettant de faire varier la fréquence.

Cet appareil permet à la fois d'appliquer une polarisation continue au niveau du dipôle et de mesurer la capacité du condensateur $C_{ext}$ 12, et la capacité équivalente du dipôle $C_{dipôle}$. Elle permet aussi de déterminer la capacité totale de l'ensemble en association parallèle $C_{tot}$. Celle-ci correspond à la somme de la capacité équivalente du dipôle avec celle du condensateur du circuit soit :

$$C_{tot} = C_{dipôle} + C_{ext}.$$

L'admittance mesurée est décrite de façon générale par une association parallèle d'une conductance G et d'une capacité C. L'instrument de mesure est raccordé à un ordinateur. Cet ordinateur pilote cet instrument afin de pouvoir effectuer des mesures systématiques en fonction de la polarisation continue et de la fréquence du courant alternatif généré par le générateur de tension 14.

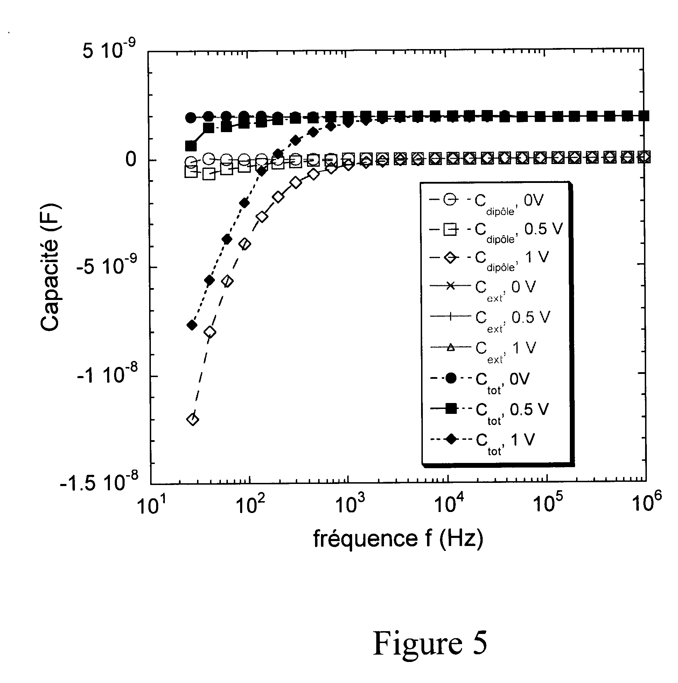

On procède dans un premier temps à des mesures sur la capacité du condensateur $C_{ext}$ pour trois valeurs de tension 0V, 0.5V et 1V. Pour cela le condensateur $C_{ext}$ est branché directement sur l'instrument de mesure. La capacité mesurée pour ces trois valeurs est de 1,9nF. Cette capacité est indépendante de la tension continue et de la fréquence comme on peut le voir sur la figure 5, qui est un graphe de valeurs des différentes capacités se rapportant aux condensateurs $C_{dipôle}$, $C_{ext}$, $C_{tot}$, pour des fréquences et tensions définies au niveau de l'ordinateur.

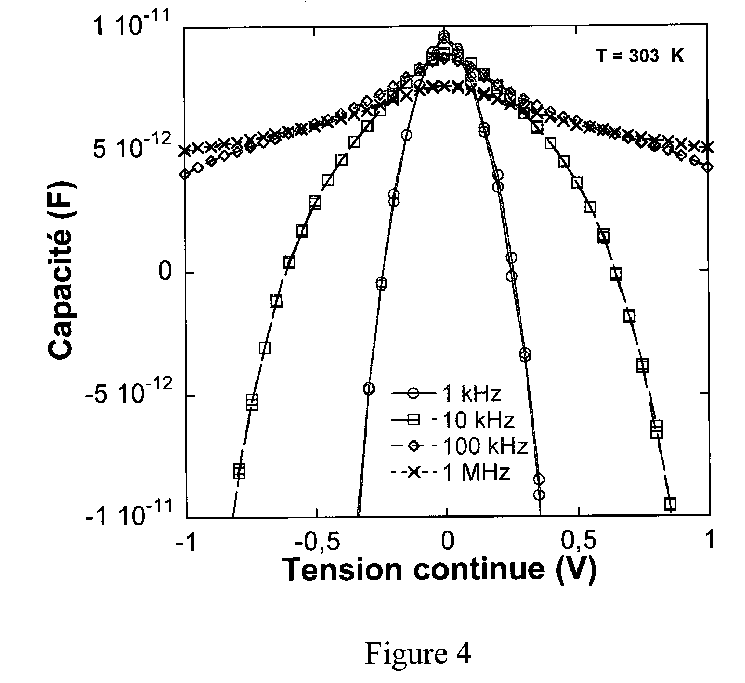

On procède de la même façon avec la capacité équivalente du dipôle $C_{dipôle}$. À partir des figures 4 et 5 on remarque que pour une tension continue nulle, $C_{dipôle}$ est très faible et positive de l'ordre de quelques pF. Pour les valeurs de tension continue de 0.5V et 1V, $C_{dipôle}$ devient négatif à basse fréquence. On obtient pour une tension continue de 1V des capacités en valeurs absolues supérieures à 10nF pour des fréquences inférieures à 30Hz. Ces valeurs sont beaucoup plus grandes que celles qui sont obtenues à 0V en valeur absolue. La figure 4 illustre bien les différentes valeurs prises par $C_{dipôle}$ pour des tensions continues et des fréquences définies par l'ordinateur qui pilote l'instrument de mesure. La capacité du dipôle $C_{dipôle}$ change de signe pour une valeur de tension continue d'autant plus petite que la fréquence est petite. Lorsque l'on augmente l'intensité du champ électrique au-delà de la valeur provoquant le changement de signe de la capacité, la variation s'accentue; on peut ainsi atteindre des valeurs de capacité négative nettement plus grandes que la valeur positive mesurée à tension continue nulle.

Notons qu'on peut ajuster la valeur à une fréquence donnée en appliquant une tension ad hoc; la plage de tension utile est facilement accessible et est de l'ordre du volt.

En effectuant la mesure de l'ensemble en parallèle $C_{tot}$, on peut apprécier l'effet du dispositif sur la capacité $C_{ext}$. La somme des capacités mesurées pour $C_{dipôle}$ avec $C_{ext}$ est égale à la capacité mesurée $C_{tot}$, quelle que soit la tension continue appliquée.

À partir de l'ordinateur, en faisant varier les tensions à 0 V et 0,5 V, $C_{tot}$ prend des valeurs positives que ce soit pour des hautes ou des basses fréquences.

Pour une tension continue positionnée à 1V, avec une haute fréquence de tension alternative générée par le générateur de tension 14, la capacité du dipôle $C_{dipôle}$ est positive et très faible par rapport à celle du condensateur du circuit $C_{ext}$, et on mesure bien une capacité totale positive pratiquement égale à $C_{ext}$. À basse fréquence, $C_{dipôle}$ prend des valeurs négatives importantes, l'ensemble fait bien apparaître un décalage et $C_{tot}$ devient elle-même négative lorsque $|C_{dipôle}| > C_{ext}$.

Donc au-delà d'une certaine tension et en basse fréquence, il apparaît un décalage de capacité significatif, et le circuit peut alors avoir des temps de réponse réduits. Pour des tensions suffisamment grandes la capacité apparente de l'ensemble peut elle-même devenir négative. Ainsi, pour une tension appliquée de 1 V, la valeur $C_{tot}$ est de l'ordre de - $3,2.10^{-8}$ F, bien inférieure à la valeur nominale du condensateur $C_{ext}$ dans le circuit extérieur.

Les propriétés électriques du dipôle ne dépendant que de la valeur absolue de la tension et non de son signe, on obtient le même comportement pour des tensions négatives, et donc par exemple la même valeur de $C_{tot}$ à -1 V qu'à +1 V.

En conclusion, il apparaît que les fortes variations avec la tension de la capacité du dipôle $C_{dipôle}$ contribuent à faire varier notablement la capacité de l'ensemble $C_{tot}$. Celle-ci peut être éventuellement augmentée, mais aussi diminuée, voire être rendue nulle ou même négative.

En faisant varier la tension continue appliquée entre la première électrode 2 et la deuxième électrode 6, la capacité $C_{dipôle}$ du dipôle est commandable et permet de compenser le condensateur $C_{ext}$ afin d'obtenir la valeur $C_{tot}$ désirée. La variation de cette tension est dans ce mode de réalisation contrôlée par l'ordinateur.

En outre la variation de la capacité du dispositif est directement liée à la variation de l'intensité du champ électrique parcourant ce dispositif. En faisant varier cette intensité, on fait varier la valeur de la capacité. Différents paramètres tels que par exemple :

- la variation de la tension du dispositif,
- la variation de l'épaisseur de la couche du matériau semi-conducteur à transport électronique par saut,
- la composition de ce matériau semi-conducteur,

permettent de faire varier l'intensité du champ électrique et par conséquent la valeur de la capacité dans toute une gamme de fréquence désirée.

Par ailleurs, le dispositif tel que décrit ne nécessite, non exclusivement, qu'une seule source de tension continue et les valeurs de cette tension peuvent être très faibles.

Il est entendu que l'invention peut s'inscrire dans un dispositif compatible avec les technologies du silicium et peut être intégré au-dessus de la surface d'un support assez fin de matériau semi-conducteur comme un plaquette de silicium. En effet, le dipôle 1 peut être réalisé par dépôts, comme nous l'avons vu précédemment, à des températures suffisamment basses pour ne pas perturber les dispositifs et circuits intégrés préalablement sur la tranche de silicium.

**Revendications**

1. Dispositif pour faire varier la valeur apparente d'une capacité à des fréquences inférieures à 10Khz, ledit dispositif étant **caractérisé en ce qu'**il comprend :

   - un dipôle (1) de type connu en soi, comprenant un matériau semi-conducteur(4) à transport électronique par saut positionné entre une première électrode (2) et une deuxième électrode (6), ledit dipôle (1) étant disposé en parallèle de ladite capacité (12), ledit dipôle se composant d'un substrat de verre (15), d'une couche d'un alliage de nitrure de carbone amorphe hydrogéné (16) constituant le semi-conducteur (16) et d'une couche d'aluminium pour chacune des électrodes (17, 18),
   - un générateur de tension continue (13) relié électriquement à la deuxième électrode (6) et à la première électrode (2) dudit dipôle (1);
   - des moyens pour faire varier la tension générée par le générateur (13).

2. Dispositif selon la revendication 1, comprenant un générateur de tension alternatif (14) disposé en série avec ledit générateur de tension continue (13).

3. Dispositif selon la revendication 1, dans lequel la première électrode (2) comprend une ligne métallique de première électrode (10) et une surface de contact de première électrode (8), et la deuxième électrode (6) comprend une ligne métallique de deuxième électrode (11) et une surface de contact de deuxième électrode (9), ledit matériau semi-conducteur (4) étant positionné entre ladite ligne métallique de première électrode (10) et ladite ligne métallique de deuxième électrode (11), ledit générateur (13) étant relié électriquement à la première électrode (2) et à la deuxième électrode (6) respectivement au niveau de la surface de contact de première électrode (8) et de la surface de contact de deuxième électrode (9).

4. Dispositif selon la revendication 1 dans lequel le dipôle (1) se compose d'un substrat de verre (7) et d'une succession de couches suivantes :

   - une couche d'aluminium (6) constituant la première électrode (2),
   - une couche d'un alliage titane tungstène (5),
   - une couche d'un alliage de nitrure de carbone amorphe hydrogéné (4) constituant le semi-conducteur (4),
   - une couche d'un alliage de titane tungstène (3),
   - et une couche d'aluminium (2) constituant la deuxième électrode (6).

5. Procédé pour faire varier la valeur apparente d'une capacité à des fréquences inférieures à 10Khz, ledit procédé comprenant des étapes consistant à :

   - positionner en parallèle :

     • ladite capacité (12)
     • un dipôle (1) de type connu en soi, comprenant un matériau semi-conducteur (4) à transport électronique par saut positionné entre une première électrode (2), une deuxième électrode (6), ledit dipôle se composant d'un substrat de verre (15), d'une couche d'un alliage de nitrure de carbone amorphe hydrogéné (16) constituant le semi-conducteur (16) et d'une couche d'aluminium pour chacune des électrodes (17, 18),
     • et un générateur de tension continu (13) relié électriquement à la première électrode (2) et à la deuxième électrode (6),

   - appliquer une tension continue aux bornes de ladite première électrode (2) et de ladite deuxième électrode (6),
   - faire varier ladite tension générée par le générateur.

6. Procédé selon la revendication 5, comprenant une étape consistant à faire varier ladite tension jusqu'à une valeur, ladite valeur étant choisie de sorte que la valeur apparente de ladite capacité (12) soit négative.

7. Procédé selon la revendication 5, comprenant une étape consistant à faire varier ladite tension jusqu'à une valeur, ladite valeur étant choisie de sorte que la valeur apparente de ladite capacité (12) soit nulle.

8. Procédé selon la revendication 5, comprenant une étape supplémentaire dans laquelle un générateur de tension alternative (14) est positionné en série avec ledit générateur de tension continue.

**9.** Procédé selon la revendication 8, comprenant une étape consistant à sélectionner une fréquence d'une tension alternative générée par le générateur de tension alternative (14) lorsque ladite tension continue est fixée, de telle sorte que la valeur apparente de ladite capacité (12) soit négative.

**10.** Procédé selon la revendication 8, comprenant une étape consistant à sélectionner une fréquence d'une tension alternative générée par le générateur de tension alternative (14) lorsque ladite tension continue est fixée, de telle sorte que la valeur apparente de ladite capacité (12) soit nulle.

**Patentansprüche**

**1.** Vorrichtung zum Variieren des Scheinwerts einer Kapazität bei Frequenzen unter 10 kHz, Vorrichtung **dadurch gekennzeichnet, dass** sie Folgendes umfasst:

- einen Dipol (1) des an solchen bekannten Typs, der ein Halbleitermaterial (4) mit Elektronentransport durch Sprung umfasst, das zwischen einer ersten Elektrode (2) und einer zweiten Elektrode (6) positioniert ist, wobei der Dipol (1) parallel zu der Kapazität (12) angeordnet ist, wobei der Dipol aus einem Glassubstrat (15), einer Schicht aus einer Legierung aus amorphem hydriertem Kohlenstoffnitrid (16), die den Halbleiter (16) bildet, und einer Aluminiumschicht für jede der Elektroden (17, 18) besteht,
- einen Gleichspannungsgenerator (13), der elektrisch mit der zweiten Elektrode (6) und mit der ersten Elektrode (2) des Dipols (1) verbunden ist,
- Mittel zum Variieren der von dem Generator (13) erzeugten Spannung.

**2.** Vorrichtung nach Anspruch 1, die einen Wechselspannungsgenerator (14) umfasst, der mit dem Gleichspannungsgenerator (13) in Serie geschaltet ist.

**3.** Vorrichtung nach Anspruch 1, wobei die erste Elektrode (2) eine Metallleitung der ersten Elektrode (10) und eine Kontaktoberfläche der ersten Elektrode (8) umfasst, und die zweite Elektrode (6) eine Metallleitung der zweiten Elektrode (11) und eine Kontaktoberfläche der zweiten Elektrode (9) umfasst, wobei das Halbleitermaterial (4) zwischen der Metallleitung der ersten Elektrode (10) und der Metallleitung der zweiten Elektrode (11) positioniert ist, wobei der Generator (13) elektrisch mit der ersten Elektrode (2) und mit der zweiten Elektrode (6) jeweils im Bereich der Kontaktoberfläche der ersten Elektrode (8) und der Kontaktoberfläche der zweiten Elektrode (9) verbunden ist.

**4.** Vorrichtung nach Anspruch 1, wobei der Dipol (1) aus einem Glassubstrat (7) und einer Abfolge folgender Schichten besteht:

- eine Aluminiumschicht (6), die die erste Elektrode (2) bildet,
- eine Schicht aus einer Titan-Wolfram-Legierung (5),
- eine Schicht aus einer Legierung aus amorphem hydriertem Kohlenstoffnitrid (4), die den Halbleiter (4) bildet,
- eine Schicht aus einer Titan-Wolfram-Legierung (3),
- und eine Aluminiumschicht (2), die die zweite Elektrode (6) bildet.

**5.** Verfahren zum Variieren des Scheinwerts einer Kapazität bei Frequenzen unter 10 kHz, wobei das Verfahren Schritte umfasst, die aus Folgendem bestehen:

- parallel Positionieren:

-- der Kapazität (12)
-- eines Dipols (1) eines als solchen bekannten Typs, der ein Halbleitermaterial (4) mit Elektronentransport durch Sprung umfasst, der zwischen einer ersten Elektrode (2), einer zweiten Elektrode (6) positioniert ist, wobei der Dipol aus einem Glassubstrat (15), einer Schicht aus einer Legierung aus amorphem hydriertem Kohlenstoffnitrid (16), die den Halbleiter (16) bildet, und aus einer Aluminiumschicht für jede der Elektroden (17, 18) besteht,
-- und aus einem Gleichspannungsgenerator (13), der elektrisch mit der ersten Elektrode (2) und der zweiten Elektrode (6) verbunden ist,

- Anlegen einer Gleichspannung an die Klemmen der ersten Elektrode (2) und der zweiten Elektrode (6),
- Variieren der von dem Generator erzeugten Spannung.

**6.** Verfahren nach Anspruch 5, das einen Schritt umfasst, der darin besteht, die Spannung bis zu einem Wert zu variieren, wobei der Wert derart ausgewählt ist, dass der Scheinwert der Kapazität (12) negativ ist.

**7.** Verfahren nach Anspruch 5, das einen Schritt umfasst, der darin besteht, die Spannung bis zu einem Wert zu variieren, wobei der Wert derart ausgewählt ist, dass der Scheinwert der Kapazität (12) null ist.

**8.** Verfahren nach Anspruch 5, das einen zusätzlichen Schritt umfasst, bei dem ein Wechselspannungsgenerator (14) in Serie mit dem Gleichspannungsgenerator geschaltet ist.

**9.** Verfahren nach Anspruch 8, das einen Schritt umfasst, der darin besteht, eine Frequenz einer Wechselspannung auszuwählen, die von dem Wechselspannungsgenerator (14) erzeugt wird, wenn die Gleichspannung festgelegt ist, so dass der Scheinwert der Kapazität (12) negativ ist.

**10.** Verfahren nach Anspruch 8, das einen Schritt umfasst, der darin besteht, eine Frequenz einer Wechselspannung auszuwählen, die von dem Wechselspannungsgenerator (14) erzeugt wird, wenn die Gleichspannung festgelegt ist, so dass der Scheinwert der Kapazität (12) null ist.

**Claims**

**1.** A device for varying the apparent value of a capacitance, said device being **characterised in that** it comprises:

- a dipole (1) of a known type, comprising an electronic hopping transport semiconductor material (4) placed between a first electrode (2) and a second electrode(6), said dipole (1) being arranged in parallel with said capacitance (12), the dipole being made up of a glass substrate (15), a layer of a hydrogenated amorphous carbon nitride alloy (16) constituting the semiconductor (16), and a layer of aluminium for each of the co-planar electrodes (17, 18);
- a direct voltage generator (13) connected electrically to the second electrode (6) and to the first electrode (2) of said dipole (1);
- means for varying the voltage generated by the generator (13).

**2.** A device according to claim 1, comprising an alternating voltage generator (14) arranged in series with said direct voltage generator (13).

**3.** A device according to claim 1, wherein the first electrode (2) comprises a metallic line of first electrode (10) and a contact surface of first electrode (8), and the second electrode (6) comprises a metallic line of second electrode (11) and a contact surface of second electrode (9), said semiconductor material (4) being placed between said metallic line of first electrode (10) and said metallic line of second electrode (11), said generator (13) being connected electrically to the first electrode (2) and to the second electrode (6) respectively at the level of the contact surface of first electrode (8) and at the contact surface of second electrode (9).

**4.** A device according to claim 1, wherein the dipole (1) is made up of a glass substrate (7) and a succession of the following layers:

- a layer of aluminium (6) constituting the first electrode (2),
- a layer of titanium-tungsten alloy (5),
- a layer of a hydrogenated amorphous carbon nitride alloy (4) constituting the semiconductor (4), a layer of a titanium-tungsten alloy (3),
- and a layer of aluminium (2) constituting the second electrode (6).

**5.** A method for varying the apparent value of a capacitance, said method comprising steps involving:

- placing the following in parallel:

  • said capacitance (12)
  • a dipole (1) of a known type, comprising an electronic hopping transport semiconductor material (4) placed between a first electrode (2) and a second electrode (6), the dipole being made up of a glass substrate (15), a layer of a hydrogenated amorphous carbon nitride alloy (16) constituting the semiconductor (16), and a layer of aluminium for each of the co-planar electrodes (17, 18),
  • and a direct voltage generator (13) connected electrically to the first electrode (2) and to the second electrode (6),

- applying a direct voltage to the terminals of said first electrode (2) and of said second electrode (6),
- varying said voltage generated by the generator.

**6.** A method according to claim 65 comprising a step consisting of varying said voltage up to a value, said value being chosen so that the apparent value of said capacitance (12) is negative.

**7.** A method according to claim 5, comprising a step consisting of varying said voltage up to a value, said value being chosen so that the apparent value of said capacitance (12) is zero.

**8.** A method according to claim 5, comprising an additional step, wherein an alternating voltage generator (14) is placed in series with said direct voltage generator.

**9.** A method according to claim 8, comprising a step consisting of selecting an alternating voltage frequency generated by the alternating voltage generator (14) when said direct voltage is fixed, so that the apparent value of said capacitance (12) is negative.

10. A method according to claim 8, comprising a step consisting of selecting an alternating voltage frequency generated by the alternating voltage generator (14) when said direct voltage is fixed, so that the apparent value of said capacitance (12) is zero.

Figure 1

Figure 2

EP 2 036 116 B1

Figure 3

Figure 4

Figure 5

EP 2 036 116 B1

EP 2 036 116 B1

17

18

16

15

Figure 7

EP 2 036 116 B1

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 5558477 A
- WO 9628847 A
- US 2004207486 A

**Littérature non-brevet citée dans la description**

- **LATESSA,-L. ; PECCHIA,-A. ; DI-CARLO,-A. ; LUGLI,-P.** Negative quantum capacitance of gated carbon nanotubes. *Physical-Review-B-Condensed-Matter-and-Materials-Physics.,* 15 Juillet 2005, 35455-1, 5
- **KLEIDER-JP ; GUDOVSKIKH-A. ; GODET-C.** High-field transport in amorphous carbon and carbon nitride films. *Journal of Non-Crystalline Solids,* 15 Juin 2004, vol. 338-340, 349-352